# EUROPEAN PATENT APPLICATION

(11) **EP 4 535 955 A1**
(43) Date of publication of application: **09.04.2025**
(21) Application number: 24203528.5
(22) Date of filing: 30.09.2024
(51) Int. Cl.: H10D 8/01, H10D 8/60, H10D 62/832, H10D 64/62, H10D 64/64

(54) **ONE-STEP FRONT OHMIC AND SCHOTTKY CONTACT FORMATION ON SIC POWER DEVICES WITH LASER ANNEALING**

(30) Priority: 03.10.2023 US 202318376091
(71) Applicant: STMicroelectronics International N.V., 1228 Plan-les-Ouates, Geneva (CH); Consiglio Nazionale Delle Ricerche, 00185 Roma (IT)
(72) Inventor: RASCUNÀ, Simone, 95129 CATANIA (IT); BELLOCCHI, Gabriele, 95124 CATANIA (IT); BADALÀ, Paolo, 95024 ACIREALE (CT) (IT); VIVONA, Marilena, 91013 CALATAFIMI SEGESTA (TP) (IT); ROCCAFORTE, Fabrizio, 95030 MASCALUCIA (CT) (IT)
(74) Representative: Studio Torta S.p.A.

(57) **Abstract**

Methods, systems, and apparatuses for one step formation of ohmic contacts and Schottky contacts for SiC power devices by using laser annealing are provided. An SiC power device may include a back-side ohmic contact, a n+ substrate, a n- epitaxial layer, one or more p+ regions, one or more carbon layers, one or more ohmic contacts, and a Schottky contact. The one or more ohmic contacts and Schottky contact may be formed in a one step operation that may include laser annealing. During manufacturing, a metallization layer applied above the carbon layers and n-epitaxial layer may form the ohmic contacts and Schottky contacts when the annealing is performed.

## Description

### TECHNOLOGICAL FIELD

The present invention relates generally to silicon carbide (SiC) power devices, particularly to SiC power devices with both ohmic and Schottky contacts formed in one-step.

### BACKGROUND

Silicon carbide (SiC) power devices, such as SiC diodes, may include both an ohmic contact and a Schottky contact. Examples of SiC diodes include a JBS (junction barrier Schottky) diodes and MPS (merged PN Schottky) diodes. In these SiC diodes an ohmic contact may be formed under the Schottky contact. Conventional manners of forming the ohmic contact and Schottky contact include multiple metallization layers that require multiple steps. For example, some of these steps include ohmic contact formation on p+ regions needing a dedicated metal deposition (e.g., Ni), multiple steps associated with photolithography for the metal definition, and a first annealing process at temperatures of nearly 1000°C. Subsequently, the formation of Schottky contacts then need a second metal deposition and another, separate, annealing process at temperatures of up to 500°C.

These conventional manners of manufacturing, including the separate annealing processes to separately form ohmic contacts and Schottky contacts, have increased process complexity and increased the probability of errors occurring. Additionally, they include multi-step lithographic processes that increase the cost of manufacturing and of the resultant power device.

Thus, an aim of the invention is to overcome the disadvantages of the prior art.

### SUMMARY

According to the invention, a method of manufacturing a SiC power device and a SiC power device are provided, as defined in the appended claims.

Various embodiments described herein relate to an improved one step formation of ohmic contacts and Schottky contacts for SiC power devices. These ohmic contacts and Schottky contacts are on a first side-a front side-of a SiC power device and may be formed at the same time with a single annealing operation.

A method of manufacturing a SiC power device may comprise providing a wafer with a plurality of SiC layers, wherein the plurality of SiC layers include a n- epitaxial layer and one or more p+ regions, wherein the wafer has a first surface comprised of one or more surface areas of the n- epitaxial layer and one or more surface areas of the one or more p+ regions; applying a first laser to the first surface; forming, in response to applying the first laser to the first surface, one or more carbon layers on the first surface, wherein each of the one or more carbon layers are formed on the one or more surface areas of the one or more p+ regions; depositing a metallization layer on the first surface; annealing the wafer; and forming, in response to annealing the wafer, one or more ohmic contacts and one or more Schottky contacts.

In some embodiments, annealing the wafer is performed by an annealing laser.

In some embodiments, the annealing laser has an energy density below 3 Joule/square centimeter.

In some embodiments, annealing the wafer is performed in an annealing oven.

In some embodiments, applying the first laser to the first surface includes applying a plurality of scans of the first laser.

In some embodiments, applying the first laser to the first surface does not cause one or more carbon formations on the one or more surface areas of the n- epitaxial layer.

In some embodiments, the one or more p+ regions are arranged in one or more stripes.

In some embodiments, the one or more p+ regions are arranged in one or more cells.

In some embodiments, forming the one or more ohmic contacts and one or more Schottky contacts comprises the one or more ohmic contacts located beneath the one or more Schottky contacts.

In some embodiments, the n- epitaxial layer is comprised of 4H-SiC.

A SiC power device may comprise a plurality of SiC layers, wherein the plurality of SiC layers include a n- epitaxial layer and one or more p+ regions; one or more carbon layers, wherein each of the one or more carbon layers is above one of the one or more p+ regions; one or more ohmic contacts, wherein each of the one or more ohmic contacts is associated with and above one of the one or more carbon layers; one or more Schottky contacts, wherein each of the one or more Schottky contacts is above and associated with the n- epitaxial layer; and wherein the one or more ohmic contacts and the one or more Schottky contacts have been formed at the same time with annealing.

In some embodiments, the one or more carbon layers are comprised of graphite.

In some embodiments, each of the one or more carbon layers are aligned above an associated p+ region.

In some embodiments, there are no carbon layers above the n- epitaxial layer.

In some embodiments, the SiC power device further comprises an n+ substrate in contact with the n- epitaxial layer.

In some embodiments, the N+ substrate is comprised of 4H-SiC.

In some embodiments, the SiC power device further comprises a back-side ohmic contact in contact with the n+ substrate.

In some embodiments, the one or more ohmic contacts and are located beneath the Schottky contact.

In some embodiments, the n- epitaxial layer is comprised of 4H-SiC.

In some embodiments, the p+ regions are of doped 4H-SiC.

### BRIEF DESCRIPTION OF THE DRAWINGS

For the understanding of the present invention, embodiments are now described, purely as non-limitative examples, with reference to the accompanying drawings, which are not necessarily drawn to scale, and wherein:
FIG. 1 illustrates a first cross-section view of a block diagram of a first exemplary power device in accordance with one or more embodiments of the present invention;
FIG. 2A illustrates a first plan view of a block diagram of a first exemplary semiconductor wafer in accordance with one or more embodiments of the present invention;
FIG. 2B illustrates a second plan view of a block diagram of a second exemplary semiconductor wafer in accordance with one or more embodiments of the present invention;
FIGS. 3A-3D illustrate example block diagrams associated with operations for preparing a power device in accordance with one or more embodiments of the present invention;
FIG. 4 illustrates a graph associated with the formation of carbon layers in accordance with one or more embodiments of the present invention;
FIGS. 5A-5B illustrate a cross-section view associated with the formation of carbon layers in accordance with one or more embodiments of the present invention; and
FIG. 6 illustrates an example flowchart of operations for forming ohmic and Schottky contacts in accordance with one or more embodiments of the present invention.

### DETAILED DESCRIPTION

Some embodiments of the present invention will now be described more fully herein with reference to the accompanying drawings, in which some, but not all, embodiments of the disclosure are shown. Indeed, various embodiments of the disclosure may be embodied in many different forms, without departing from the scope of the invention as defined in the appended claims. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

Various embodiments of the present disclosure are directed to improved one step formation of ohmic contacts and Schottky contacts for SiC power devices by using annealing.

Various embodiments of SiC power devices may include diodes and rectifiers. For example, SiC power devices may be junction barrier Schottky (JBS) diodes or Merged PN Schottky (MPS) diodes. Power devices of a JBS or a MPS are each a combination of different diodes, such as a Schottky diode and a PN diode in parallel. Manufacturing SiC power diodes, including JBS diodes and MPS diodes, includes forming both ohmic contacts and Schottky contacts.

Various embodiments of the present disclosure include forming an ohmic contact on implanted p+ regions and at the same time forming a Schottky contact on an epitaxial layer that is not the implanted p+ regions. The ohmic contact and the Schottky contact may be formed at the same time in one step as described herein.

The ohmic contact may be formed by a reaction between a metallization layer (e.g., Ni) and a carbon layer (e.g., graphite).

The carbon layer may be formed on a p-implanted SiC region(s) by applying a laser with a low laser energy. The formation of the carbon layer by using a laser allows for the carbon layer to be aligned with the p-implanted region. This alignment may be such that the carbon layer is directly on top of the p-implanted region without forming on an adjacent epitaxial layer while extending to the edges of the p-implanted region. The metallization layer may be deposited over the carbon layer and surrounding epitaxial layer. Then by applying an annealing operation (e.g., laser annealing) an ohmic contact and an Schottky contact may be formed in one step. The ohmic contact forms just over the carbon layer and a Schottky contact is formed over the epitaxial layer where the carbon layer was not present.

The present disclosure includes a number of advantages, including one metallization layer used for formation of both ohmic contacts and Schottky contacts, lower annealing temperatures, and omitting lithographic operations for forming the ohmic contacts and the Schottky contacts.

Embodiments of the present disclosure herein include systems and apparatuses with ohmic contacts and Schottky contacts for SiC power devices being formed in one step, such as by using laser, which are described herein and may be implemented in various embodiments.

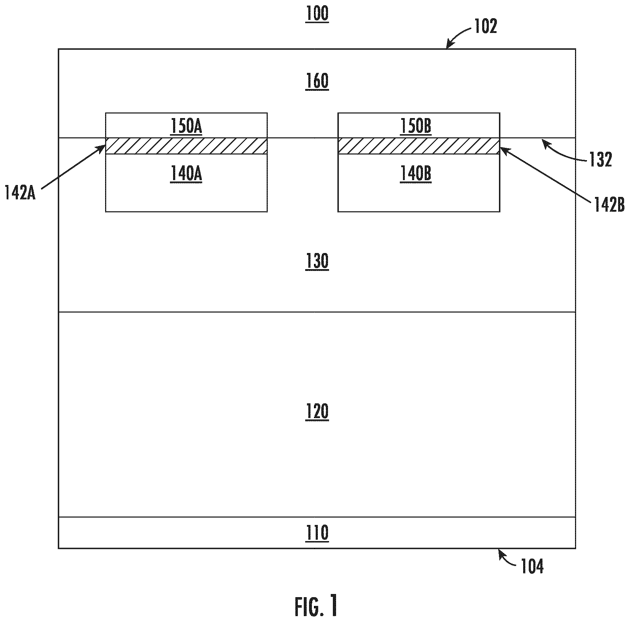

FIG. 1 illustrates a first cross-section view of a block diagram of a first exemplary power device 100 in accordance with one or more embodiments of the present invention. The power device 100 has a front-side 102 and a back-side 104.

The power device 100 includes multiple layers and regions. The power device 100 may include a back-side ohmic contact 110, a n+ substrate 120, a n- epitaxial layer 130, one or more p+ regions 140 (e.g., 140A, 140B), one or more carbon layers 142 (e.g., 142A, 142B), one or more ohmic contacts 150 (e.g., 150A, 150B), and a Schottky contact 160. Thus, the SiC power devices has one or more ohmic contacts 150 and a Schottky contact 160. In various embodiments, the side of the SiC device 100 illustrated at the bottom of the figure is a back-side and the side of the SiC device 100 illustrated at the top of the figure is a front-side.

The p+ regions 140 may be formed from the n- epitaxial layer 130 via implantation that may dope the n- epitaxial layer 130 with a metal (e.g., aluminum) to form the doped p+ regions 140. In various embodiments, a plurality of power devices 100 may be manufactured at the same time on a wafer and the p+ regions may be formed in stripes or cells on the wafer, which is described further herein.

In various embodiments, the n+ substrate may be a 4H-SiC substrate. The n- epitaxial layer 130 may be a 4H-SiC epitaxial layer. This n- epitaxial layer 130 may sustain certain breakdown voltage(s) and control the doping of the p+ regions 140. The p+ regions 140 may be a p doped 4H-SiC region.

The ohmic contacts 150 may be formed above the p+ regions 140. In particular, a carbon layer 142 may be formed above the p+ region 140 and the ohmic contact 150 may be formed from the carbon layer 142 during annealing.

The ohmic contact 150 may be aligned with the associated p+ region 140 such that the ohmic contact 150 is directedly above the carbon layer 142 and p+ region without extending or spilling over onto an adjacent portion of the n- epitaxial layer 130. Also, this alignment of the ohmic contact 150 may include the ohmic contact being formed so that it goes to the lateral edge of the associated carbon layer 142 and associated p+ region 140.

In various embodiments, if there was a misalignment of the ohmic contact 150 that would be outside of the p+ region 140 and overlapped the n- epitaxial layer 130 then the device would underperform and not be suitable for use. The alignment is due, in part, to the one-step formation of the ohmic contacts and the Schottky contacts as described herein.

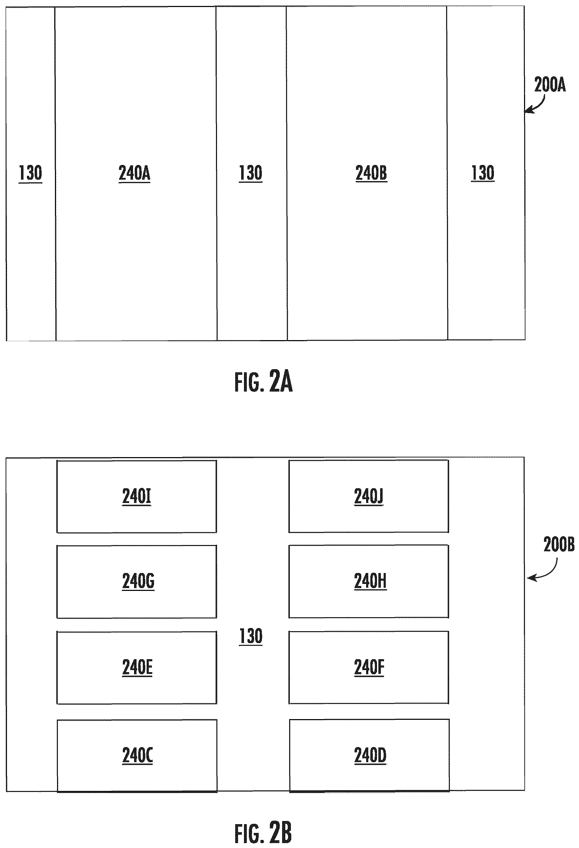

In various embodiments multiple SiC power devices 100 may be manufactured on a wafer, and the wafer may have a plurality of p+ regions 140 formed from the n- epitaxial layer 130. The p+ regions 140 may be formed in different patterns. For example, the p+ region may be formed in one or more stripes and/or one or more cells. These different patterns are illustrated in FIGS. 2A and 2B.

FIG. 2A illustrates a first plan view of a block diagram of a first exemplary semiconductor wafer in accordance with one or more embodiments of the present invention. The plan view of FIG. 2A illustrates a top-down view of a wafer 200A having two stripes 240A, 240B of p+ regions 140 on an n- epitaxial layer 130.

FIG. 2B illustrates a second plan view of a block diagram of a second exemplary semiconductor wafer in accordance with one or more embodiments of the present invention. The plan view of FIG. 2B illustrates a top-down view of a wafer 200B having multiple p+ regions 140 of cells 240C-240J on or in an n- epitaxial layer 130.

It will be appreciated that while FIG. 2A illustrates an example of two stripes 240A, 240B and FIG. 2B illustrates an example of eight cells 240C-240J, various embodiments may include a wafer with additional or fewer stripes and/or cells.

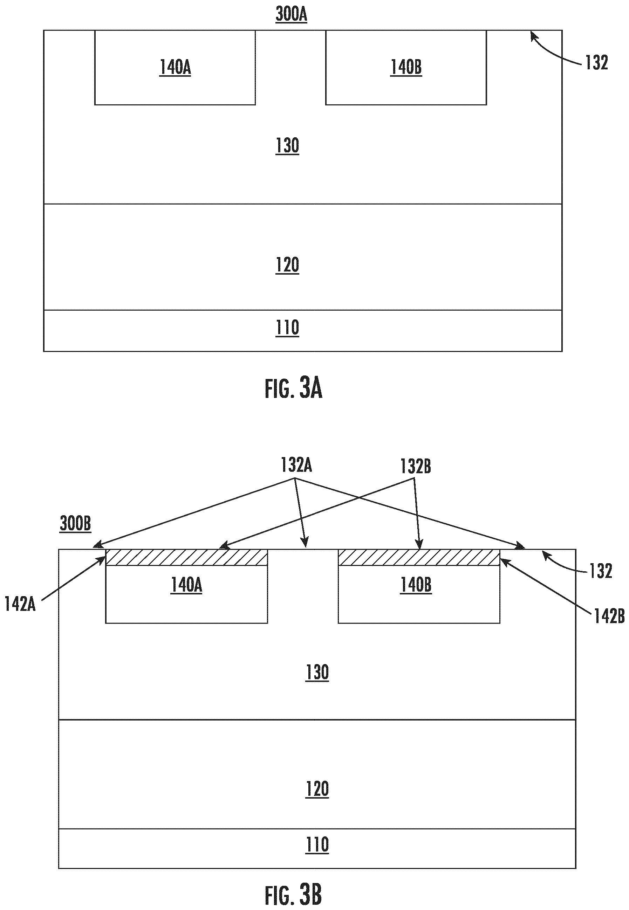

FIGS. 3A-3D illustrate example block diagrams associated with operations for preparing a power device in accordance with one or more embodiments of the present invention. In various embodiments, a power device 100 may be manufactured as described herein. The examples illustrated in FIGS. 3A-3D provide illustrations in accordance with those operations.

FIG. 3A illustrates a wafer 300A being provided with a back-side ohmic contact 110, a n+ substrate 120, a n- epitaxial layer 130, and a plurality of p+ regions 140.

In various embodiments, the present disclosure may be used to manufacture or form multiple diodes on a single wafer.

A first surface 132, which is a top-side surface, includes a first surface of the plurality of p+ regions 140 and a first surface of the n- epitaxial layer 130.

A laser annealing operation may be performed to this first surface 132 as described herein to form or generate carbon layers 142 above or on the p+ regions without forming carbon layers above or on the n- epitaxial layer 130.

FIG. 3B illustrates a wafer 300B after a first annealing. The first anneal may be with a laser and may form or generate carbon layers 142 (142A, 142B in Figure 3B) above or on the p+ regions 140 (140A, 140B in Figure 3B) without forming carbon layers above or on the n- epitaxial layer 130. This may be done by, among other things, using an annealing laser with power densities above a first threshold and below a second threshold as described herein. The first threshold may be a power density that would form a carbon layer 142 on a p+ region. The second threshold may be a power density that would form a carbon layer on a n- epitaxial layer. The second threshold is higher than the first threshold. Using laser annealing above the first threshold and below the second threshold forms carbon layer(s) 142 only above the p+ regions 140 without forming carbon layer(s) on the n- epitaxial layer 130. In various embodiments, this laser may be an excimer laser.

The carbon layer(s) 142 formed on or above the p+ region(s) 140 are aligned with the respective p+ region(s) 140 due to the laser annealing. This alignment allows for a carbon layer 142 to be directly on or above a p+ region 140 without overlapping or spilling over on or above a n- epitaxial layer 130. This may be due to a portion of the p+ region 140 being formed into the carbon layer 142. Also, the formation of the carbon layer(s) 142 allows for the first surface 132 to include the surface of the n- epitaxial layer 130 and the surfaces of the carbon layers 132B.

In various embodiments, the carbon layer 142 may be a carbon induced formation layer that includes a 3C-SiC region and/or a 6H-SiC region, such as described herein.

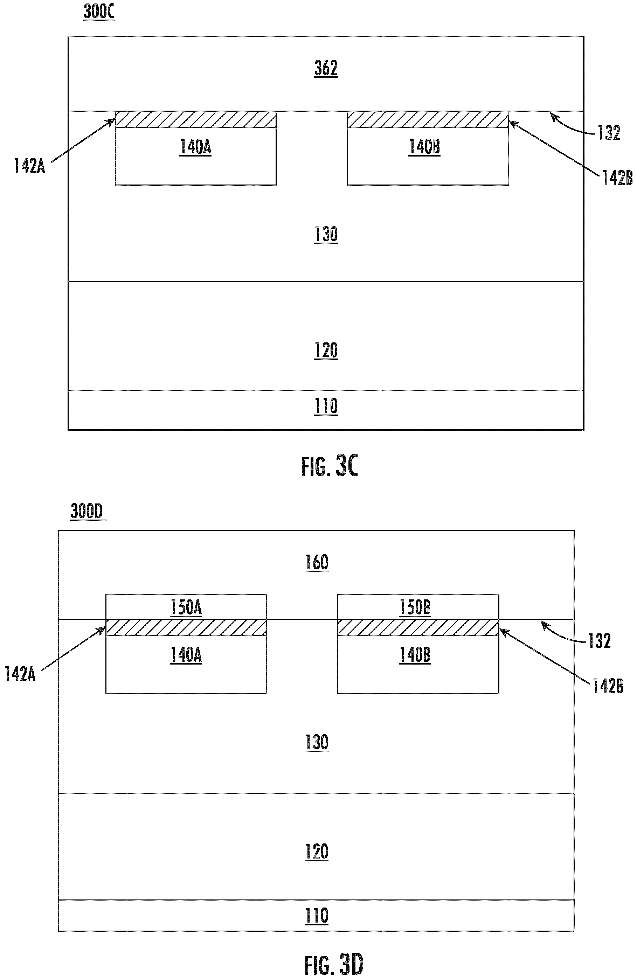

FIG. 3C illustrates a wafer 300C with a metallization layer 362 having been deposited on the first surface 132. In various embodiment the metal of the metallization layer 362 may be titanium or nickel. This metallization layer 362 may be deposited with a thickness associated with or based on a desired barrier for the Schottky contact. This barrier height may also be based on the metal of the metallization layer 362. The deposition of the metallization layer 362 cover the exposed top-side at surface 132 of the n- epitaxial layer 130 and carbon layers 142.

The formation of the ohmic contacts 150 is by a reaction between metal of the metallization layer 362 and the carbon layers 142 (in particular, 142A and 142B in Figure 3C). The formation of the Schottky contact(s) 160 is by a reaction between metal of the metallization layer 362 and the n- epitaxial layer 130. The reaction is obtained by thermal annealing, such as by laser annealing or by using an oven. In various embodiments using laser annealing, the laser used may be an excimer laser.

FIG. 3D illustrates a wafer 300D after the annealing operation that formed the ohmic contacts 150 and Schottky contact 160. The Schottky contact 160 covers the ohmic contacts 150. The Schottky contact 160 and the ohmic contacts 150 are formed at the same time by the annealing process.

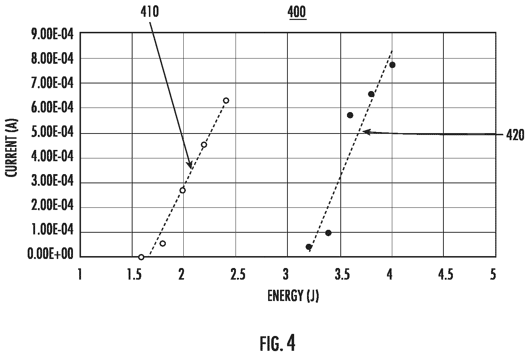

FIG. 4 illustrates a graph associated with the formation of carbon layers in accordance with one or more embodiments of the present invention. The graph 400 has an energy of a laser used for forming carbon layers on the x-axis and a current on the y-axis. The current on the y-axis is measured for the conductance of the first surface, which begins to conduct when a carbon formation (e.g., graphite) is formed or induced on the surface. As current starting to flow is an indication that carbon formation is occurring. Before the carbon layer(s) are formed, the current is zero.

Need almost twice the energy to get carbon formation on a region with n- epitaxial layer that is without implantation. In various embodiments this is because performing implantation causes damage to the SiC crystals. This damage assists with the growth of the carbon layer formation at lower energy densities than for areas that are not implanted. In contrast, for a non-implanted region, the energy to break the covalent bonds of the epitaxy is higher.

With reference to Figure 4, the first line 410 is associated with a carbon layer formed on a p+ region and the second line 420 is associated with a carbon layer formed on a n- epitaxial layer. The first line 410 begins to conduct or not have a current of zero at an energy of 1.6 J. The second line 420 begins to conduct or not have a current of zero at an energy greater than 3 J. As illustrated, the carbon layer formed on a p+ region forms at a lower amount of energy density applied to the surface than when the carbon layer on a n- epitaxial layer forms at line 420.

As illustrated, the laser annealing process will only form a carbon layer on the surface of the p+ regions and not on the n- epitaxial layer when a laser above 1.5 J and below 3 J is used.

This formation of carbon layers only on the p+ regions by laser annealing process allows for forming carbon aligns aligned with the p+ regions without overlapping the n- epitaxial layers. In various embodiments the alignment may be a perfect alignment for the formation of carbon layers is perfectly aligned above the p+ regions. The alignment of the carbon layers allows for formation of an improved ohmic contact. The ohmic contact behavior is mainly related to the carbon layer formation.

With the laser annealing process to form carbon layers, the laser annealing may be applied to the entirety of the surface. This allows for the laser annealing process without requiring shielding or masking.

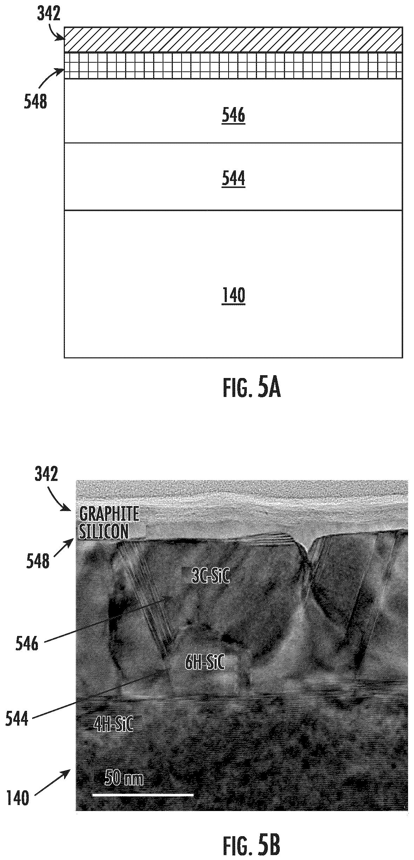

FIG. 5A illustrates a cross-section view associated with the formation of carbon layers in accordance with one or more embodiments of the present invention. The cross-section view includes a carbon layer 342, a silicon layer 548, a second layer 546, a first layer 544 and a p+ region 140. The cross-section view of FIG. 5A illustrates layers formed in response to application of a laser, such as during operations described herein. The carbon layer 342 may overlay the silicon layer 548. The silicon layer 548 may overlay the second layer 546. The second layer may overlay the first layer 544. The first layer may overlay the p+ region 140.

In various embodiments, the p+ region may be comprised of 4H-SiC. The application of the laser to the p+ region may cause one or more bonds of the p+ 4H-SiC to be broken, which may form the first layer 544, the second layer 546, the silicon layer 548, and the carbon layer 142.

In various embodiments, the first layer 544 may be comprised of 6H-SiC and the second layer 546 may be comprised of 3C-SiC. The silicon layer 548 may be comprised of silicon. The carbon layer 342 may be comprised of graphite. In various embodiments, the layers may be within the first 50 nanometers of the p+ region 140.

It will be appreciated that the layers illustrated in FIG. 5A may not be as clearly separated as illustrated in FIG. 5A. The layers may be comprised of crystal structures that may be rearranged as bonds are broken.

In various embodiments, the first layer 544 and the second layer 546 may be formed side-by-side instead of on top and bottom of each other as illustrated in FIG. 5A.

FIG. 5B illustrates a cross-section view associated with the formation of carbon layers in accordance with one or more embodiments of the present invention. FIG. 5B is a zoomed in image of the layers of FIG. 5A in an exemplary embodiment. As illustrated in FIG. 5B, the layers are not evenly separated.

It should be readily appreciated that the embodiments of the systems and apparatuses, described herein may be configured in various additional and alternative manners in addition to those expressly described herein, without departing from the scope of the invention as defined in the appended claims.

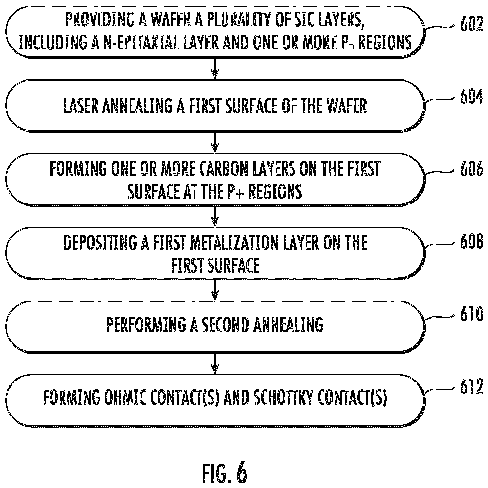

FIG. 6 illustrates an example flowchart of operations for forming ohmic and Schottky contacts in accordance with one or more embodiments of the present invention.

At operation 602, a wafer with a plurality of SiC layers, including an n- epitaxial layer and one or more p+ regions, is provided.

In various embodiments, the plurality of SiC layers may include a n+ substrate 120 and a n- epitaxial layer 130.

In various embodiments the one or more p+ regions 140 may be formed in stripes (e.g., 240A, 240B) and/or in cells (e.g., 240C-240J).

In various embodiments the wafer may also include a back-side ohmic contact 110. The wafer may have a first surface 132 that is a top-side surface. The first surface 132 may be comprised of one or more surface areas of the n- epitaxial layer 130 and one or more surface areas of the one or more p+ regions 140.

In various embodiments, a wafer may be provided with just a n- epitaxial layer and doping may occur to form the p+ 140 regions prior to the wafer being provided.

At operation 604, laser annealing of a first surface of the wafer may be performed. The first surface 132 may be exposed and may be laser annealed. In various embodiment the laser annealing may be with an excimer laser.

In various embodiments, this laser anneal may be performed with a pulse duration of 160 ns.

The laser annealing may have a power density between 1 J/cm² and 3 J/cm².

The laser may be used to perform one or more scans to perform the laser annealing. For example, 1 to 20 scans may be used. In other embodiments the number of scans may vary with the energy density of the laser.

The laser annealing of operation 604 is performed so that carbon layers are not formed on the surface of the n- epitaxial layer 130.

At operation 606, one or more carbon layers are formed on the surface of the p+ regions. The carbon layers 142 are formed on the p+ regions 140 in response to the laser annealing of operation 604. Thus, each of the one or more carbon layers 142 is uniquely associated with one or more surface areas of the one or more p+ regions 140 where the respective carbon layer 142 is formed.

The carbon layer(s) 142 may be formed so that they are aligned with the respective p+ region 140. This alignment may be due the use of laser annealing at operation 604. The alignment of the carbon layers 142 to an associated p+ region 140 is such that the carbon layer 142 does not overlap the nearby n- epitaxial layer 130. A carbon layer 142 is formed or generated on a p+ region 140. Thus, the first surface 132 is now comprised of n- epitaxial surface area 132A and one or more surface areas of the one or more carbon layers 132B (as shown in Figure 3B).

At operation 608, a metallization layer is deposited on the first surface. The metal of the metallization layer 362 is deposited to cover the first surface 132 to cover the n- epitaxial surface area 132A and one or more surface areas of the one or more carbon layers 132B.

At operation 610, a second annealing is performed. The second annealing forms one or more ohmic contacts 150 and one or more Schottky contacts 160 at the same time.

In various embodiments, the second annealing may be performed at a medium annealing temperature of 400 °C to 500 °C.

In various embodiments, the second annealing may be performed with an annealing laser. This laser may an excimer laser. In various embodiments, the second annealing may be performed in an oven.

At operation 612, ohmic contact(s) and Schottky contact(s) are formed. In response to the second annealing operation 610, the one or more ohmic contacts 150 may be formed at the carbon layers 142 and the Schottky contact 160 may be formed at the n- epitaxial layers 130.

For the carbon layers 142, the second annealing operation creates an alloy that is the ohmic contact. In various embodiments, the entirety of a carbon layer 142 may not interact to form an ohmic contact and thus there may be some of the carbon layer 142 remaining.

It should be readily appreciated that the embodiments described herein may be configured in various additional and alternative manners in addition to those expressly described herein, including adding or omitting one or more operations, without departing from the scope of the invention as defined in the appended claims.

Operations and/or functions of the present disclosure have been described herein, such as in flowcharts. As will be appreciated, computer program instructions may be loaded onto a computer or other programmable apparatus (e.g., hardware) to produce a machine, such that the resulting computer or other programmable apparatus implements the operations and/or functions described in the flowchart blocks herein. These computer program instructions may also be stored in a computer-readable memory that may direct a computer, processor, or other programmable apparatus to operate and/or function in a particular manner, such that the instructions stored in the computer-readable memory produce an article of manufacture, the execution of which implements the operations and/or functions described in the flowchart blocks. The computer program instructions may also be loaded onto a computer, processor, or other programmable apparatus to cause a series of operations to be performed on the computer, processor, or other programmable apparatus to produce a computer-implemented process such that the instructions executed on the computer, processor, or other programmable apparatus provide operations for implementing the functions and/or operations specified in the flowchart blocks. The flowchart blocks support combinations of means for performing the specified operations and/or functions and combinations of operations and/or functions for performing the specified operations and/or functions. It will be understood that one or more blocks of the flowcharts, and combinations of blocks in the flowcharts, can be implemented by special purpose hardware-based computer systems which perform the specified operations and/or functions, or combinations of special purpose hardware with computer instructions.

While this specification contains many specific embodiments and implementation details, these should not be construed as limitations on the scope of the invention as defined in the appended claims, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

## Claims

1. A method of manufacturing an SiC power device comprising:
providing (602) a wafer with a plurality of SiC layers, wherein the plurality of SiC layers include a n- epitaxial layer (130) and one or more p+ regions (140A, 140B), wherein the wafer has a first surface (132) comprised of one or more surface areas of the n- epitaxial layer and one or more surface areas of the one or more p+ regions;
applying (604) a first laser to the first surface;
forming (606), in response to applying the first laser to the first surface, one or more carbon layers (142A, 142B) on the first surface, wherein each of the one or more carbon layers are formed on the one or more surface areas of the one or more p+ regions (140A, 140B);
depositing (608) a metallization layer (362) on the first surface (132);
annealing (610) the wafer; and
forming (612), in response to annealing the wafer, one or more ohmic contacts (150A, 150B) and one or more Schottky contacts (160).

2. The method of claim 1, wherein applying the first laser to the first surface (132) does not cause one or more carbon formations on the one or more surface areas of the n- epitaxial layer (130).

3. The method of claim 1 or 2, wherein the first laser has a power density above a first threshold causing formation of a carbon layer on a p+ region and below a second threshold causing formation of a carbon layer on an n- epitaxial layer.

4. The method of any of claims 1-3, wherein the first laser has an energy density below 3 Joule/square centimeter.

5. The method of claim 1, wherein annealing the wafer is performed by an annealing laser or in an annealing oven.

6. The method of any of claims 1-5, wherein applying the first laser to the first surface includes applying a plurality of scans of the first laser.

7. The method of any of the preceding claims, wherein the one or more p+ regions are arranged in one or more stripes (240A, 240B) or in one or more cells (240C-240J).

8. The method of any of the preceding claims, wherein forming the one or more ohmic contacts (150) and one or more Schottky contacts (160) comprises the one or more ohmic contacts located beneath the one or more Schottky contacts.

9. The method of any of the preceding claims, wherein the n- epitaxial layer (130) is comprised of 4H-SiC.

10. An SiC power device (100) comprising:
a plurality of SiC layers, wherein the plurality of SiC layers include a n- epitaxial layer (130) and one or more p+ regions (140A, 140B);
one or more carbon layers (142A, 142B, 342), wherein each of the one or more carbon layers is above one of the one or more p+ regions;
one or more ohmic contacts (150A, 150B), wherein each of the one or more ohmic contacts is associated with and above one of the one or more carbon layers;
one or more Schottky contacts (160), wherein each of the one or more Schottky contacts is above and associated with the n- epitaxial layer (130).

11. The SiC power device of claim 10, wherein the one or more ohmic contacts and the one or more Schottky contacts have been formed at the same time with annealing.

12. The SiC power device of claim 10 or 11, wherein the one or more carbon layers (142A, 142B, 342) are comprised of graphite.

13. The SiC power device of any of claims 10-12, wherein each of the one or more carbon layers (142A, 142B) are aligned above an associated p+ region (140A, 140B).

14. The SiC power device of any of claims 10-13, wherein there are no carbon layers above the n- epitaxial layer (130).

15. The SiC power device of any of claims 10-14, wherein the one or more p+ regions are of doped 4H-SiC, the SiC power device further comprising a first layer (544) of 6H-SiC and a second layer (546) of 3H-SiC arranged between the one or more p+ regions and the one or more carbon layers.
